Europäisches Patentamt
European Patent Office
Office européen des brevets

(19) (11) Publication number: 0 100 920 B1

(12) EUROPEAN PATENT SPECIFICATION

(45) Date of publication of patent specification: 16.07.86
(21) Application number: 83107030.5
(22) Date of filing: 18.07.83
(51) Int. Cl.[4]: G 03 C 5/00, G 03 F 7/02, H 01 J 29/22, G 03 C 1/54, G 03 F 7/08

(54) **Photosensitive composition and pattern forming process using same.**

(30) Priority: 11.08.82 JP 138534/82

(43) Date of publication of application: 22.02.84 Bulletin 84/08

(45) Publication of the grant of the patent: 16.07.86 Bulletin 86/29

(84) Designated Contracting States: DE GB NL

(56) References cited:
EP-A-0 042 704
DE-A-2 815 894
FR-A- 659 998
GB-A-1 192 088
GB-A-1 293 396
GB-A-2 005 855
GB-A-2 087 580

J. KOSAR: "Light-sensitive systems: Chemistry and application of nonsilver halide photographic processes", 1965, pages 267-269, John Wiley & Sons, Inc., New York, USA

M.S. DINABURG: "Photosensitive diazo compounds and their uses", 1964, pages 29-31, 77-80, 87-91, The focal Press, London, G.B.

(73) Proprietor: HITACHI, LTD.
6, Kanda Surugadai 4-chome Chiyoda-ku
Tokyo 100 (JP)

(72) Inventor: Morishita, Hajime
24-1, Chuo-6-chome
Ota-ku Tokyo (JP)
Inventor: Akagi, Motoo
2196-146, Hirai Hinodecho
Nishitama-gun Tokyo (JP)
Inventor: Nonogaki, Saburo
17-24, Kamimeguro-3-chome
Meguro-ku Tokyo (JP)
Inventor: Hayashi, Nobuaki
400-228, Kubo Hidakacho
Iruma-gun Saitama-ken (JP)
Inventor: Uchino, Shoichi
47-1-D401, Akatsukicho-1-chome
Hachioji-shi (JP)

(74) Representative: Patentanwälte Beetz sen. - Beetz jun. Timpe - Siegfried - Schmitt-Fumian
Steinsdorfstrasse 10
D-8000 München 22 (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).



Courier Press, Leamington Spa, England.

**Description**

This invention relates to photosensitive compositions and a method of forming patterns employing these compositions.

The inner surface of the screen-faceplate of color picture tubes is coated with three different kinds of phosphors arranged in dots or stripes. A known method of forming this phosphor coating layer is as follows. First, a coating material of a mixture composed of the phosphor of the first color and a photosensitive resin is applied on the inner surface of the faceplate and dried to form a coating film. Then, this film layer is irradiated with ultraviolet radiation through the apertures of a shadow mask, the locations so irradiated being those at which the electron beam is to impinge to cause the phosphor to emit luminescence radiation, i.e. the locations at which the phosphor is to be secured. The photosensitive resin of the respective irradiated portions becomes insoluble, so that the whole layer at these locations is insoluble. Next, the coating layer is washed with a solvent, to leave only the insoluble parts on the faceplate surface and to dissolve and remove the other parts.

Subsequently, similar operations are performed with a layer formed from a mixture of the phosphor of the second color and the photosensitive resin, and then with a mixture consisting of the phosphor of the third color and the photosensitive resin.

As is apparent from the foregoing explanation, this process is complicated and requires the repetition of the multiple coating, washing and drying. Accordingly, a simplification of the process is very desirable.

To this end, it has previously been proposed (JP—A—126861/78, DE—A—2815894) a method of forming the phosphor screen of color picture tubes which is conspicuously simpler than the prior art method. This method is based on the finding that the photolysis products or aromatic diazonium salts have the ability to retain powder particles. This method comprises the following steps:

(a) coating the inner surface of the faceplate of a color picture tube with a thin layer of a photosensitive composition containing an aromatic diazonium salt as photosensitive component and becoming sticky when exposed to light,

(b) exposing the thin layer to light in desired pattern to cause stickiness in the exposed areas, and

(c) contacting the exposed thin layer with powder particles so that the powder particles adhere to the exposed portions.

In this method, only the exposure and the powder contacting need to be rpeated for the phosphors of the second and the third color, and once the coating film has been formed, patterns of any number of different phosphors can be formed. This method, however, has the disadvantage that the processing time is rather long due to the somewhat lower sensitivity of the photosensitive component than with conventional photosensitive compositions.

To overcome this problem sensitizers for photosensitive compositions have previously been proposed (JP—A—17543/82) which have a somewhat improved sensitivity.

As described in the above-mentioned JP—A—126861/78 the powder contacted with the coating film adheres even to the non-exposed portions causing the so-called "fogging" phenomenon, if the coating film containing the photosensitive component is not in a crystallized state. The above-mentioned sensitizers are somewhat inferior in crystallinity when used in coating films. Further, when used in photosensitive compositions in large quantities, these sensitizers show increased sensitizing effects but simultaneously the fogging phenomenon becomes more serious.

The EP—A2—42704 describes a photosensitive composition becoming sticky when exposed which comprises a p-dialkylaminobenzene diazonium salt eventually substituted in the benzene nucleus as photosensitive component. Also these photosensitive comopsitions do not show satisfactory sensitivities.

Accordingly, there was a demand for developing sensitizers having a high sensitizing effect even in small quantities or sensitizers having excellent crystallinity by themselves.

It is an object of this invention to provide photosensitive compositions of high sensitivity for use in the above-mentioned pattern forming method. This object is accomplished by the claims 1 and 7. The dependent claims refer to the preferred embodiments.

The photosensitive compositions according to the invention, which become sticky upon exposure to light, comprise an aromatic diazonium compound and are characterized by a mixture of

(A) at least one phenoldiazonium compound of the formulae Ia or Ib

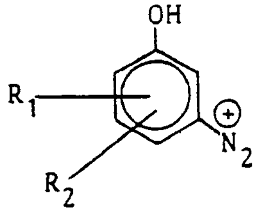

(Ia)

or

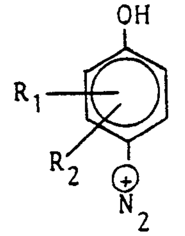

,

(Ib)

wherein

$R_1$ and $R_2$ are independently H, $—CH_3$ or $—OCH_3$, or one of $R_1$ and $R_2$ is

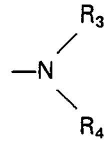 ,

whereby $R_3$ and $R_4$ are independently straight chain lower alkyl groups, and

(B) an aromatic diazonium compound having no phenolic OH group,

the compounds (A) and (B) each being present in the form of a chloride-zinc chloride double salt, a tetrafluoroborate or a hydrogen sulfate.

The method of the invention for forming powder patterns comprises the steps of

(a) coating a substrate with a thin coating layer of a photosensitive composition comprising a salt of a diazonium compound,

(b) exposing said coating layer to light in a desired pattern to cause the exposed portions to become sticky

and

(c) contacting the exposed coating layer with powder particles so that the powder particles adhere to the exposed portions.

The method is characterized in that a photosensitive composition as defined above is used in step (a).

The aforementioned general formulae Ia and Ib of the compound A show that the OH group must be in m- or p-position relative to the position of the diazonium group. In other words, the diazonium group and the OH group cannot be in o-position to each other.

The salts of the compound A represented by the aforementioned general formula Ia and Ib and the salt of the aromatic diazonium compound B having no phenolic OH group are chloride-zinc chloride double salts ($Cl\cdot\frac{1}{2}ZnCl_2$ or $Cl\cdot ZnCl_2$), tetrafluoroborates ($BF_4$) and hydrogen sulfates ($HSO_4$). Among them, chloride-zinc chloride double salts are preferable for the following reasons.

As described earlier, if the photosensitive coponent of the coating film is not crystallized, the phosphor powder sometimes adheres even to the non-exposed potions of the film. Accordingly, the coating film must be crystallized. The use of diazonium chloride-zinc chloride double salts is preferable, because it gives excellent crystallinity and the coating layer accepts a large quantity of phosphor powder.

In the above general formulae Ia and Ib of compound A, $R_3$ and $R_4$ are preferably $C_1$- or $C_2$-alkyl groups, because these compounds give also excellent crystallinity. When $R_3$ and $R_4$ both are methyl, the crystallinity is best.

Compounds A represented by the general formulae Ia and Ib include, for example:

4-Hydroxybenzenediazonium chloride-zinc chloride double salt

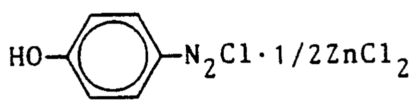 (2);

3-Hydroxy-4-dimethylaminobenzenediazonium chloride-zinc chloride double salt

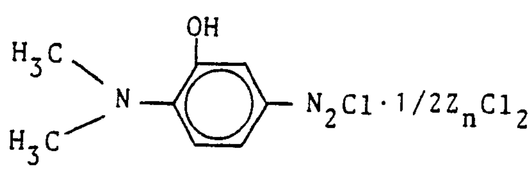 (3);

4-Hydroxy-3-dimethylaminobenzenediazonium chloride-zinc chloride double salt

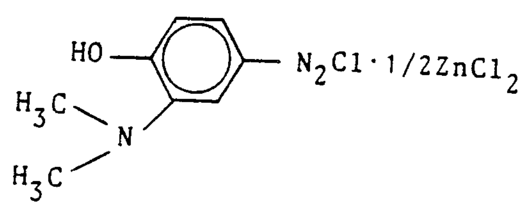 (4);

4-Hydroxy-2-dimethylaminobenzenediazonium chloride-zinc chloride double salt

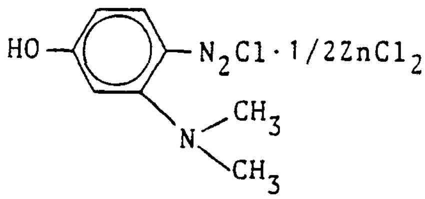

(5).

The diazonium compound of the formulae Ia and Ib can be used alone or as mixtures thereof.

These compounds A are highly sensitive but per se not particularly superior in crystallinity. For this reason they are used together with salts of aromatic diazonium compounds B having no phenolic OH groups in the molecule. Such aromatic diazonium compounds B are for example, salts of 4-(N-ethyl-N-hydroxyethylamino)-benzenediazonium. These salts of compound B can also be used alone or as mixtures thereof.

As the salts of the aromatic diazonium compound B there may be used compounds described in the aforementioned JP—A—126861/78. Examples for the compounds B are 4-dimethylaminobenzenediazonium salts, 4-(N-ethyl-N-hydroxyethylamino)-benzenediazonium chloride zinc chloride double salt, 4-methoxybenzenediazonium chloride zinc chloride double salt, 2-methoxybenzenediazonium tetrafluoroborate salt, 4-phenylaminobenzenediazonium sulfate, 2-methyl-4-dimethylaminobenzenediazonium chloride zinc chloride double salt and the like.

Among said salts, the zinc chloride double salts are preferred in view of the crystallinity of the coating film as mentioned above. It is particularly preferable to use 4-dimethylaminobenzenediazonium chloride-zinc chloride double salt, even in the case of using two or more salts B in admixture.

The quantity of the salt of the diazonium compound A represented by the formulae Ia and Ib is preferably in the range of 1 to 60% by weight, more preferably in the range of 2 to 50% by weight and most preferably in the range of 5 to 30% by weight, based on the total weight of compounds A and B. Using of this salt A in an amount of 1% by weight shows only a slight sensitizing effect but the effect becomes significant by addition of A in an amount of 2% or more. The effect becomes remarkable when the salt A is added in an amount of 5% by weight or more. When its content exceeds 50% by weight, the coating films show the tendency of reduced crystallinity to some extent. If the amount of A exceeds 60% by weight, the coating film shows further reduced crystallinity. When an organic polymer is added to the photosensitive composition of this invention as described later, the crystallinity of the coating film is somewhat reduced if the salt of the diazonium compound A is used in an amount of only 30% by weight or more.

It has already been proposed to incorporate an organic polymer and/or a surfactant into the photosensitive compositions for improving the coatability when forming a thin layer. This applies also for the photosensitive compositions of this invention. The organic polymer recommendable for use according to this invention for said purpose include gum arabic, polyvinyl alcohol, polyacrylamide, poly(N-vinylpyrrolidone), hydroxypropylmethyl cellulose, alginic acid, propylene glycol esters of alginic acid, acrylamide-diacetonacrylamide copolymers and methylvinyl ether-maleic anhydride copolymers. These organic polymers are preferably used in an amount of 0.5% to 500% by weight, more preferably of 0.5 to 100% by weight and most preferably of 0.5 to 50% by weight, based on the total weight of A and B. The surfactant is preferably used in a quantity of about 0.01 to 1% by weight.

In the present invention, a pattern is formed by applying a solution of said composition onto a substrate, drying it to form a coating film, exposing this coating film to light in a predetermined pattern to cause the exposed portions to become sticky, then contacting the exposed coating layer with a first powder so that the powder adheres to the exposed portions, removing the rest of the powder by suitable means such as compressed air, and repeating the above process for the second and third powders. In this way, a pattern of several different kinds of powders can be formed.

The powders used in this invention are those having a mean particle size of about 0.01 to 100 µm. In the case of using phosphors or pigment-coated phosphors, it is preferable to use powders having a mean particle size of about 4 to 15 µm.

As known e.g. from the aforementioned JP—A—126861/78 the thus formed phosphor coating layer can then be fixed by contacting it with the vapor of an alkaline material such as ammonia gas.

In the following, this invention will be explained with reference to examples. At first, the synthesis methods for compounds A are explained.

Synthesis example 1

15 g of p-aminophenol were dissolved in a mixture of 35 ml of concentrated hydrochloric acid (36%) and 30 ml of water. To the resulting mixture a 30% aqueous sodium nitrite solution was added dropwise at 0 to 1°C until the diazotization was complete.

Then, a 50% zinc chloride solution was poured therein to form a zinc chloride double salt. The double salt was recrystallized from an acidic 5% zinc chloride solution to obtain the compound of the formula (2).

Synthesis example 2

50 g of 2-methoxy-4-nitroaniline were reacted with 200 ml of dimethyl sulfate for 30 min at 100°C. After allowing to cool, the reaction mixture was treated with a 30% aqueous sodium hydroxide solution to obtain 2-methoxy-4-nitro-N,N-dimethylaniline. Then, this comound was reacted with $AlCl_3$ in benzene for 4 to 5 h at 50°C to transform the methoxy group into a phenolic OH group and to obtain 2-hydroxy-4-nitro-N,N-dimethylaniline. After reduction of this compound, diazotization was conducted in the same manner as in Synthesis Example 1 and thereafter zinc chloride was added to obtain the compound of the formula (3).

Synthesis example 3

The methoxy group of 2-methoxy-5-nitroso-N,N-dimethylaniline was converted into a phenolic OH-group in a similar manner as described in Synthesis example 2. After reduction and diazotization, the compound of the formula (4) was obtained.

Example 1

4-Hydroxybenzenediazonium chloride-zinc chloride double salt of the formula (2) and 4-dimethylaminobenzenediazonium chloride-zinc chloride double salt were mixed in a weight ratio of 1 to 9. Then an aqueous solution containing 5% of propylene glycol alginate was added so that the solid proportion became 10% by weight, based on the total weight of the diazonium compounds A and B. The resulting mixture was coated onto a glass substrate by spin coating. The coating layer was dried to obtain a crystallized film having a thickness of about 0.5 µm. The film was exposed to light for 160 s through a shadow mask at a distance of 135 cm with a 500 W super-high pressure mercury arc lamp. Subsequently, a phosphor powder was contacted with the exposed film, whereby the phosphor powder adhered to the exposed portions of the film. For comparison a similar procedure was carried out using only 4-dimethylaminobenzenediazonium chloride-zinc chloride double salt and propylene glycol alginate without using the compound of the formula (2). In order to fix about the same quantity of the phosphor, an exposure time of 250 s was necessary.

By repeating the above exposure and contacting with phosphor two more times, a phosphor pattern consisting of three kinds of adhering phosphors could be obtained.

Example 2

Using 0.5 part by weight of the diazonium salt of the formula (2), 0.5 part by weight of the diazonium compound of the formula (4) and 9 parts by weight of 4-dimethylaminobenzenediazonium chloride-zinc chloride double salt, an experiment similar to example 1 was conducted. In order to fix about the same quantity of phosphor, an exposure time of 140 s was necessary.

Synthesis example 4

Synthesis of p-diazo-2,6-dimethylphenol chloride-zinc chloride double salt

25 g of 2,6-dimethylphenol were dissolved in 246 ml of a 50% aqueous glacial acetic acid solution. To this solution being kept at 15°C or lower were added dropwise 91 g of a 30% aqueous sodium nitrite solution, whereby 2,6-dimethyl-p-nitrosophenol was obtained. The compound was reduced to the corresponding amino compound. The amino compound was then diazotized at 0 to 2°C. Subsequently, a 50% aqueous zinc chloride solution was poured into the resulting reaction mixture. By thorough mixing, the zinc chloride double salt was deposited.

Infrared absorption spectra (KBr tablet): around 3300 $cm^{-1}$, 2200 $cm^{-1}$, 1570 $cm^{-1}$, 1080 $cm^{-1}$, 930 $cm^{-1}$; ultraviolet absorption spectra (solvent:water): absorption peak at 364 nm.

Synthesis example 5

Synthesis of p-diazo-2,5-dimethylphenol chloride-zinc chloride double salt

Using 2,5-dimethylphenol as starting material, the desired compound was synthesized in the same manner as in Synthesis example 4.

Synthesis example 6

Synthesis of p-diazo-3,5-dimethylphenol chloride-zinc chloride double salt

25 g of 3,5-dimethylphenol were dissolved in 200 g of a 5% aqueous sodium hydroxide solution. Then, 1 g of $Na_2S_2O_3 \cdot 5H_2O$ and 20 g of sodium nitrite were dissolved therein. To this solution being kept at 7°C or lower was added dropwise a solution of 27 ml of concentrated sulfuric acid dissolved in 80 ml of water, whereby 4-nitroso-3,5-dimethylphenol was deposited. Thereafter, the same procedure as in Synthesis example 4 was conducted to obtain the desired double salt.

Example 3

1 part by weight of p-diazo-2,6-dimethylphenol chloride-zinc chloride double salt and 9 parts by weight of p-diazo-N,N-dimethylaniline chloride-zinc chloride double salt were mixed. Then an aqueous solution containing 0.5% of propylene glycol alginate was added thereto so that the solids content became 10% by weight, based on the weight of the diazonium compounds A and B. The resulting mixture was coated onto a glass substrate by spin coating. The coated substrate was dried to obtain a crystallized film having a

thickness of about 0.5 µm. The film was exposed to light for 150 s through a shadow mask at a distance of 135 cm from a 500 W super-high pressure mercury arc lamp. Subsequently, a phosphor powder was contacted with the exposed film, whereby the phosphor powder adhered to the exposed portions of the film. About the same result was obtained when p-diazo-3,5-dimethylphenol chloride-zinc chloride double salt was used. For comparison a similar procedure was conducted using only p-diazo-N,N-dimethylaniline chloride-zinc chloride double salt and propylene glycol alginate. In order to fix about the same quantity of phosphor, an exposure time of 250 s was necessary.

Synthesis example 7 and Example 4

Synthesis of p-diazo-o-methoxyphenol chloride-zinc chloride double salt

Using o-methoxyphenol as starting material, the captioned compound was synthesized according to the procedure of Synthesis example 1. Then, 1 part by weight of this double salt and 9 parts by weight of p-diazo-N,N-dimethylaniline chloride-zinc chloride double salt were mixed. Subsequently, an aqueous solution containing 0.5% of propylene glycol alginate was added thereto, so that the solids content became 10% by weight, based on the weight of the diazonium compounds A and B. This mixture was coated onto a glass plate in the same manner as in examle 3, whereby a film having a thickness of 0.5 µm was formed. The film was exposed to light in the same manner as in example 3. The exposure time required for fixing a sufficient quantity of phosphor was 160 s.

**Claims**

1. Photosensitive compositions becoming sticky upon exposure to light on the basis of an aromatic diazonium compound characterized by a mixture of

(A) at least one phenoldiazonium compound of the formulae Ia or Ib,

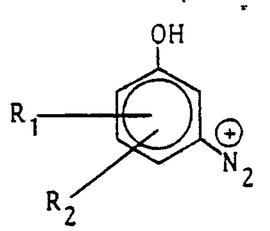

(Ia)

or

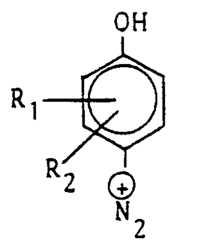

(Ib)

,

wherein

$R_1$ and $R_2$ are independently H, $—CH_3$ or $—OCH_3$,

or one of $R_1$ and $R_2$ is

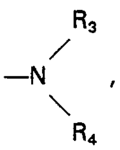

,

whereby $R_3$ and $R_4$ are independently straight chain lower alkyl groups, and

(B) an aromatic diazonium compound having no phenolic OH group,

the compounds (A) and (B) each being present in the form of a chloride-zinc chloride double salt, a tetrafluoroborate or a hydrogen sulfate.

2. Photosensitive compositions according to claim 1, characterized by 1 to 60% by weight of (A), based on the total weight of (A) and (B).

3. Photosensitive compositions according to claim 1 or 2, characterized by 2 to 50% by weight of (A), based on the total weight of (A) and (B).

4. Photosensitive compositions according to one of claims 1 to 3, characterized in that (A) is present in the form of chloride-zinc chloride double salt.

5. Photosensitive compositions according to one of claims 1 to 4, characterized in that (B) is present in the form of a chloride-zinc chloride double salt.

6. Photosensitive compositions according to one of claims 1 to 5, characterized by further comprising 0.5 to 500% by weight of an organic polymer, based on the total weight of (A) and (B).

7. A method for forming patterns of powder coating layers by

(a) coating a substrate with a thin coating layer of a photosensitive composition comprising a salt of a diazonium compound,

(b) exposing said coating layer to light in a desired pattern to cause the exposed portions to become sticky, and

(c) contacting the exposed coating layer with powder particles so that powder particles adhere to the exposed portions,

characterized by using a photosensitive composition according to one of claims 1 to 6 in step (a).

**Patentansprüche**

1. Lichtempfindliche Zusammensetzungen, die nach Belichtung klebrig werden, auf der Basis einer aromatischen Diazoniumverbindung, gekennzeichnet durch ein Gemisch von

(A) mindestens einer Phenoldiazoniumverbindung der Formel Ia oder Ib,

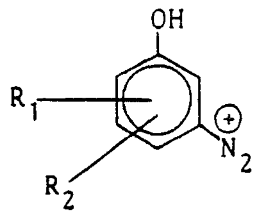

oder

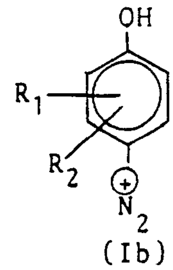

,

(Ia) (Ib)

in der

$R_1$ und $R_2$ unabhängig H, $-CH_3$ oder $-OCH_3$ sind oder einer der Reste $R_1$ oder $R_2$

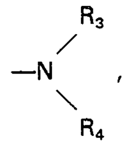

,

ist, wobei $R_3$ und $R_4$ unabhängig geradkettige niedere Alkylgruppen sind, und

(B) einer aromatischen Diazoniumverbindung ohne phenolische OH-Gruppe,

wobei die Verbindungen (A) und (B) je in Form eines Chlorid-Zinkchlorid Doppelsalzes, Tetrafluorborats oder Hydrogensulfats vorliegen.

2. Lichtempfindliche Zusammensetzungen nach Anspruch 1, gekennzeichnet durch 1 bis 60 Gew.% (A), bezogen auf das Gesamtgewicht von (A) und (B).

3. Lichtempfindliche Zusammensetzungen nach Anspruch 1 oder 2, gekennzeichnet durch 2 bis 50 Gew.% (A), bezogen auf das Gesamtgewicht von (A) und (B).

4. Lichtempfindliche Zusammensetzungen nach einem der Ansprüche 1 bis 3, gekennzeichnet durch das Vorliegen von (A) in Form eines Chlorid-Zinkchlorid-Doppelsalzes.

5. Lichtempfindliche Zusammensetzungen nach einem der Ansprüche 1 bis 4, gekennzeichnet durch das Vorliegen von (B) in Form eines Chlorid-Zinkchlorid-Doppelsalzes.

6. Lichtempfindliche Zusammensetzungen nach einem der Ansprüche 1 bis 5, gekennzeichnet durch den weiteren Gehalt von 0,5 bis 500 Gew.% eines organischen Polymers, bezogen auf das Gesamtgewicht von (A) und (B).

7. Verfahren zur Herstellung von Pulverbeschichtungsmuster durch

(a) Überziehen eines Substrats mit einer dünnen Schicht einer lichtempfindlichen, ein Salz einer Diazoniumverbindung enthaltenden Zusammensetzung,

(b) Belichten der Schicht in dem gewünschten Muster, damit die belichteten Stellen klebrig werden, und

(c) Kontaktieren der belichteten Überzugsschicht mit Pulverteilchen, so daß die Pulverteilchen auf den belichteten Stellen festkleben,

gekennzeichnet durch die Verwendung einer lichtempfindlichen Zusammensetzung nach einem der Ansprüche 1 bis 6 in Stufe (a).

**Revendications**

1. Compositions photosensibles devenant visqueuses par exposition à la lumière à base d'un composé diazoté aromatique caractérisé par un mélange de

(A) au moins un composé de phénol diazoté de formule Ia ou Ib,

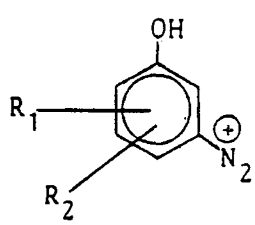

ou

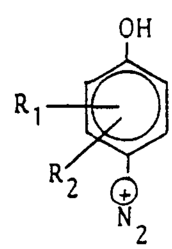

,

(Ia) (Ib)

dans laquelle

$R_1$ et $R_2$ sont indépendamment H, $—CH_3$ ou $—OCH_3$
ou l'un de $R_1$ et $R_2$ est

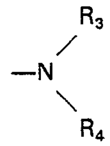 ,

$R_3$ et $R_4$ étant des groupes alkyles à chaîne droite courte indépendants et

(B) un composé aromatique diazoté ne comportant pas de groupe phénolique,

les composés (A) et (B) étant sous forme d'un sel chloreux double chlorure-chlorure de zinc d'un tétrafluoroborate ou d'un sulfate hydrogéné.

2. Compositions photosensibles selon la revendication 1 caractérisées par un rapport en poids de 1% à 60% de (A) par rapport au poids total de (A) plus (B).

3. Compositions photosensibles selon l'une quelconque des revendications 1 ou 2 caractérisées par un rapport en poids de 2% à 50% de (A) par rapport au poids total de (A) plus (B).

4. Compositions photosensibles selon l'une quelconque des revendications 1 à 3 caractérisées en ce que (A) est sous forme d'un sel double chlorure-chlorure de zinc.

5. Compositions photosensibles selon l'une quelconque des revendications 1 à 4 caractérisées en ce que (B) est sous forme d'un sel double chlorure-chlorure de zinc.

6. Compositions photosensibles selon l'une quelconque des revendications 1 à 5 caractérisées en ce qu'elles comprennent en outre 0,5% à 500% en poids d'un polymère organique par rapport au poids total de (A) plus (B).

7. Procédé de réalisation de couches de revêtement à base de poudre formant un motif consistant à

(a) revêtir un substrat d'une fine couche de revêtement de composé photosensible comprenant un sel de composé diazoté,

(b) exposer ladite couche de revêtement à la lumière selon le motif désiré de façon à rendre les parties exposées visqueuses et

(c) mettre en contact la couche de revêtement exposée avec des particules de poudre de telle sorte que des particules de poudre adhèrent aux endroits exposés,

caractérisé par l'utilisation d'une composition photosensible selon l'une quelconque des revendications 1 à 6 lors de l'étape (a).